# EUROPÄISCHE PATENTANMELDUNG

(11) **EP 2 365 650 A2**
(43) Veröffentlichungstag der Anmeldung: **14.09.2011**
(21) Anmeldenummer: 11156877.0
(22) Anmeldetag: 03.03.2011
(51) Int. Cl.: H04B 10/24

(54) **Optische Signalübertragung**

(30) Priorität: 08.03.2010 DE 202010003326 U
(71) Anmelder: Deltron Elektronische Systeme GmbH, 99994 Schlotheim (DE)
(72) Erfinder: Trautmann, Roland, 99974 Ammern (DE); Poppe, D., 99994 Mühlausen (DE); Früh, Arndt, 99713 Abtsbessingen (DE)
(74) Vertreter: WSL Patentanwälte

(57) **Zusammenfassung**

Die vorliegende Erfindung betrifft einen optischen Signalempfänger (E) mit einem elektrischen Empfängerbaustein (14) zur Verarbeitung der von einem elektrooptischen Empfangselement (8) erzeugten elektrischen Signale. Um einen kostengünstigen optischen Signalempfänger bereitzustellen, der leicht verfügbar ist und einen einfacheren Aufbau optischer Übertragungssysteme, insbesondere auch bidirektionaler Übertragungssysteme zu schaffen, wird erfindungsgemäß vorgeschlagen, dass der optische Signalempfänger (E) als elektrooptisches Empfangselement (8) für die in elektrische Signale umzuwandelnden optischen Signale eine Leuchtdiode (8) aufweist.

## Beschreibung

Diese Erfindung betrifft einen optischen Signalempfänger mit einem Empfängerbaustein, der elektrische Signale von einem optischen Empfänger aufnimmt. Außerdem betrifft die Erfindung ein optisches Signalübertragungssystem mit einem Signalsender mit einem Senderbaustein und einem Signalempfänger mit einem Empfängerbaustein. Weiter betrifft die Erfindung ein Verfahren zur optischen Signalübertragung, bei dem ein Senderbaustein ein optisches Signal sendet und das optische Signal an einen Empfängerbaustein als elektrisches Signal empfangen wird. Zudem betrifft die Erfindung ein fernsteuerbares Schließsystem mit einem optischen Signalübertragungssystem nach der Erfindung.

Optische Signalübertragungssysteme und entsprechende Verfahren werden zur Übertragung von Daten und Signalen bereits seit langer Zeit verwendet. Vielfach wird optische Datenübertragung in Fernbedienungen, aber auch in Telekommunikationsanlagen und bei der optischen Datenkommunikation in Fahrzeugen und Maschinen verwendet. Dabei wird häufig mit infrarotem Licht gearbeitet. Es ist jedoch auch eine Vielzahl von Systemen bekannt, die mit sichtbarem Licht arbeiten. Einige Beispiele finden sich in David A. Johnson, PE: "Handbook of Optical Through the Air Communications", das im Internet frei verfügbar ist.

Als Sender werden Leuchtdioden, aber auch Laserdioden und Faserlaser eingesetzt. Auf der Empfängerseite kommen im Allgemeinen Fotodioden zum Einsatz, die aufgrund ihrer kurzen Reaktionszeit besonders geeignet sind. Häufig werden Silizium- oder Germaniumdioden verwendet. Der Nachteil dieser Empfänger ist jedoch, dass sie relativ teuer sind Außerdem sind bei bidirektionalen optischen Übertragungssystemen auf beiden Seiten einer Übertragungsstrecke je ein optischer Sender, zum Beispiel in Form einer Leuchtdiode, und ein getrennter Empfänger erforderlich. Außerdem ist die Verfügbarkeit mancher Fotodiodentypen aufgrund stark schwankender Nachfrage nicht immer gegeben.

Gegenüber diesem Stand der Technik liegt bei der vorliegenden Erfindung die Aufgabe zugrunde, einen kostengünstigen optischen Signalempfänger bereitzustellen der leicht verfügbar ist und einen einfacheren Aufbau optischer Übertragungssysteme, insbesondere auch bidirektionaler Übertragungssysteme zu schaffen.

Diese Aufgabe wird dadurch gelöst, dass ein optischer Signalempfänger, der einen elektrooptischen Empfängerbaustein zur Verarbeitung der von einem optischen Empfangselement erzeugten elektrischen Signale umfasst, als elektrooptisches Empfangselement für die in elektrische Signale umzuwandelnden optischen Signale eine Leuchtdiode aufweist.

Die Erfindung basiert auf der Erkenntnis, dass Leuchtdioden nicht nur als Sender, sondern auch als Empfänger arbeiten können. Fotodioden sind Halbleiter, die eine Sperrschicht aufweisen, die von außen für Photonen zugänglich ist. Die Sperrschicht besteht aus einem Überschuss an Löchern auf der einen und einem Überschuss an Elektronen auf der anderen Seite. Durch auftreffende Photonen werden zusätzliche Elektronen-Löcher-Paare erzeugt, die die Sperrschicht überqueren können und beim Betreiben der Fotodiode in Sperrrichtung als Fotostrom abgeleitete werden können. Eine Fotodiode kann daher bei Beleuchtung als Stromquelle arbeiten, wobei die erzeugte Stromstärke proportional zur einfallenden Lichtmenge ist. Das Halbleitermaterial von Fotodioden absorbiert und wandelt Photonen möglichst breitbandig in Elektron-Loch Paare um. Der durch Photonen ausgelöste (variable) Stromfluss kann somit als Signal, das die auftreffende (variable) Lichtmenge repräsentiert, weiterverarbeitet werden. Die Fotodiode ist somit ein optoelektronischer Wandler.

Eine Leuchtdiode ist hingegen dafür vorgesehen, durch Rekombination von Elektronen und Löchern Photonen zu erzeugen. Leuchtdioden werden in Durchlassrichtung betrieben und sind so aufgebaut, dass die erzeugten Photonen von einer Metallschicht gestreut und in einer Vorzugsrichtung von der Leuchtdiode abgestrahlt werden. Leuchtdioden erzeugen dabei Photonen einer ganz bestimmten Energie und somit Licht einer bestimmten Farbe. Es hat sich jedoch herausgestellt, dass es bei entsprechender Anordnung und Ausrichtung durchaus möglich ist, bei Verwendung gleichartiger Leuchtdioden als Sender eine zweite Leuchtdiode auch in Sperrrichtung zu betreiben und damit auch als Fotodiode arbeiten zu lassen, die auftreffende Photonen in elektrische Signale umwandelt.

Als Empfängerbaustein für die so erzeugten elektrischen Signale wird vorteilhaft ein Halbleiterbauteil eingesetzt, beispielsweise ein Transistor, ein Verstärker, ein Logikgatter oder ein oder mehrere höher integrierte Halbleiterbausteine.

In einer weiteren Ausführungsform der Erfindung wird ein optisches Signalübertragungssystem mit einem Signalsender, der einen elektrischen Senderbaustein aufweist, und einem Signalempfänger, der einen elektrischen Empfängerbaustein aufweist, vorgeschlagen, wobei der Senderbaustein mit einer sendenden Leuchtdiode und der Empfängerbaustein mit einer gleichartigen empfangenden Leuchtdiode elektrisch verbunden ist.

Auf diese Weise lässt sich ein optisches Signalübertragungssystem realisieren, dass bidirektional arbeiten kann. Dabei können der Signalsender und der Signalempfänger die Rollen tauschen, wodurch in Verbindung mit Möglichkeit, mit den Leuchtdioden zu senden und zu empfangen, eine bidirektionale Übertragung ermöglicht wird. Die in einer Übertragungsrichtung empfangende Leuchtdiode wird dementsprechend in der entgegengesetzten Übertragungsrichtung zu der sendenden Leuchtdiode und umgekehrt. Das Senden und das Empfangen mit einer bestimmten Leuchtdiode findet dementsprechend nicht gleichzeitig, sondern zeitlich versetzt statt.

Die Gleichartigkeit der Leuchtdioden ist dabei dadurch definiert, dass die Leuchtdioden eine so weitreichende Ähnlichkeit haben, dass ein Empfang mit einer der Dioden möglich ist, wenn die andere sendet und umgekehrt. Die Auswahl möglichst ähnlicher Leuchtdioden stellt dabei eine optimale Ausbeute der jeweiligen Sende- und Empfangsleistung sicher. Außerdem wird die Störanfälligkeit gegenüber breitbandigen optischen Störsignalen durch die optische Filterwirkung der spektralen Empfindlichkeitsverteilung der Leuchtdioden herabgesetzt.

In einer weiteren Ausführungsform sind die sendende und die empfangende Leuchtdiode jeweils mit einem Anschluss des Sender- bzw. Empfängerbausteins elektrisch verbunden, wobei die Anschlüsse wahlweise als Eingang oder Ausgang schaltbar sind und der Anschluss des Senderbausteins entsprechend als Ausgang und der Anschluss des Empfängerbausteins als Eingang geschaltet ist und wobei die Rolle von Sender- und Empfängerbaustein austauschbar ist.

Für einen Wechsel der Übertragungsrichtung können daher auf einfache Weise die Anschlüsse des Sender- bzw. Empfängerbausteins in die andere Signalübertragungsrichtung umgeschaltet werden. Auf diese Weise ist in vorteilhafter Weise auch ein identischer Aufbau von Sender und Empfänger möglich und dementsprechend in einer bevorzugten Ausführungsform auch vorgesehen, was die Produktionskosten senkt und der optischen Signalübertragung in beide Übertragungsrichtungen die gleichen Eigenschaften verleiht.

In einer weiteren Ausführungsform haben die sendende und die empfangende Leuchtdiode dieselben Kenndaten.

Dies ist vorteilhaft, um in beide Übertragungsrichtungen gleiche Eigenschaften der Übertragung zu realisieren. Die Kenndaten beziehen sich vor allem auf die Wellenlänge, die Lichtstärke und elektrische Parameter der Leuchtdiode. Besonders vorteilhaft werden Leuchtdioden vom gleichen Hersteller mit der gleichen Typenbezeichnung eingesetzt. Wie schon erwähnt reduziert dies auch den Signal-Rausch-Abstand und die Störanfälligkeit gegenüber Fremdsignalen

In einer weiteren Ausführungsform sind die sendende Leuchtdiode und die empfangende Leuchtdiode jeweils als rote Leuchtdiode ausgeführt.

In Experimenten konnte festgestellt werden, dass die Signalübertragung mit roten Leuchtdioden besonders gute Eigenschaften aufweist, da rote Leuchtdioden offenbar auch als Empfängerdioden eine gute Ausbeute erzielen, d. h. einen hohen Anteil der auftreffenden Photonen in entsprechende elektrische Signale umwandeln.

Dabei haben sich sogenannte superhelle Leuchtdioden, d. h. Leuchtdioden mit einer maximalen Lichtstärke von mehr als 100 mcd als besonders geeignete Empfangsdioden erwiesen, die aber selbstverständlich auch als sendende Leuchtdioden besonders gut geeignet sind.

In einer weiteren Ausführungsform der Erfindung sind der Empfänger- und der Senderbaustein jeweils als Mikrocontroller ausgeführt.

Als besonders geeignet haben sich Mikrocontroller vom Typ PIC der Firma Microchip Technology Inc. herausgestellt. Alternativ können jedoch auch digitale Signalprozessoren, FPGAs, GALs oder andere programmierbare Halbleiterbausteine verwendet werden. Bei diesen Mikrocontrollern kann man in vorteilhafter dieselben Anschlusspins umprogrammieren, so dass die Umschaltung der damit verbundenen Leuchtdioden von Sende- auf Empfangselement sehr einfach durch einen (oder mehrere) Softwarebefehle erfolgen kann.

In einer weiteren Ausführungsform ist die empfangende Leuchtdiode mit dem ersten und dem zweiten Anschluss des Empfängerbausteins über ein elektrisches Netzwerk verbunden, das aus dem Signal zu dem ersten und/oder dem zweiten Anschluss einen Teil des Frequenzspektrums ausfiltert, wobei einer der Anschlüsse mit dem positiven und der andere mit dem negativen Eingang einer Signalverrechnungseinrichtung verbunden ist.

Durch ein solches elektrisches Netzwerk in Verbindung mit einer Signalverrechnungseinrichtung ist es möglich, Störungen zu unterdrücken, die sich auf der Übertragungsstrecke dem Nutzsignal überlagern. Die Signalverrechnungseinrichtung kann dabei ein Komparator oder auch ein Subtrahierer sein.

Wird ein Komparator verwendet, so wird zur Erzeugung einer Differenz zwischen den Signalen an dem ersten und dem zweiten Anschluss des Komparators vorteilhaft der Teil des Frequenzspektrums ausgefiltert, indem sich Störungen befinden. Das Nutzsignal liegt dabei vorteilhaft in einem höheren Frequenzbereich als die Störungen. Das Netzwerk weist in diesem Fall einen oder mehrere Tiefpassfilter mit einer Grenzfrequenz unterhalb der Nutzfrequenz auf. Werden die beiden anliegenden Signale, die durch die Tiefpassfilterung voneinander abweichen, im Komparator miteinander verglichen, so erscheint am Ausgang des Komparators das reine Nutzsignal. Niederfrequente Störungen werden auf diese Weise unterdrückt. Das Nutzsignal kann in Abhängigkeit davon, in welchem Signal zum Komparator gefiltert wird, auch als invertiert ausgegeben werden.

Im Falle der Verwendung eines Subtrahierers wird vorteilhaft aus einem der an dem Komparator anliegenden Signale der Frequenzbereich ausgefiltert, in dem sich das Nutzsignal befindet. Im Subtrahierer werden die anliegenden Signale voneinander abgezogen, so dass das Nutzsignal verbleibt. Das Nutzsignal kann in Abhängigkeit davon, in welchem Signal zum Subtrahierer gefiltert wird, auch invertiert als Ausgangssignal erscheinen. Die Vorrichtung mit einem Subtrahierer ist nicht auf die Ausfilterung von Störungen beschränkt, die niederfrequenter als das Nutzsignal sind.

In einer weiteren Ausführungsform ist der zweite Anschluss der Verrechnungseinheit mit einem festen internen Signal verbunden. Diese einfache Variante kann vorteilhaft eingesetzt werden, wenn nur geringe Störungen vorliegen, beispielsweise, wenn durch mechanische oder optische Maßnahmen ein Großteil der Störungen abgeschirmt werden kann. Wenn die Verrechnungseinrichtung ein Komparator und das Nutzsignal ein Digitalsignal ist, so erscheint dieses am Ausgang des Komparators als verbessertes Signal. Alternativ zur Verwendung eines Komparators kann auch ein Logikeingang verwendet werden, der mit einer internen Schaltschwelle arbeitet. Besonders gute Ergebnisse ergeben Logikeingänge mit Schmitt-Trigger-Technik.

In einer weiteren Ausführungsform ist ein zweiter Anschluss an dem Senderbaustein, der mit der sendenden Leuchtdiode verbunden ist, als Ausgang geschaltet und gibt ein konstantes Signal ab.

Durch diese Maßnahme können der Sender und der Empfänger auch mit der zuvor beschriebenen Störungsunterdrückung identisch ausgeführt werden. Der zweite Eingang des Empfängers ist dabei vorteilhaft derselbe Anschluss an demselben Baustein, wie der genannte Anschluss an dem Sendebaustein.

Das Ausgeben eines konstanten Signals hat den Vorteil, dass das Senden aus dem ersten Anschluss des Senderbausteins von dem konstanten Signal nicht gestört wird. Alternativ kann der zweite Anschluss des Senderbausteins auch als Eingang geschaltet bleiben, wodurch er ebenfalls keine Wirkung auf das gesendete Signal entfaltet.

In einer weiteren Ausführungsform sind der Sender- und der Empfängerbaustein gleiche oder vergleichbare Bausteintypen. Vorteilhaft sind die Leuchtdioden jeweils mit den gleichen Anschlüssen an jedem der Bausteine verbunden.

In einer weiteren Ausführungsform sind das Netzwerk zwischen dem ersten und dem zweiten Anschluss des Senderbausteins und der sendenden Leuchtdiode und das Netzwerk zwischen dem ersten und dem zweiten Anschluss des Empfängerbausteins und der empfangenden Leuchtdiode identisch. Vorteilhaft werden in den Netzwerken gleiche Bauteile mit gleichen Bauteilwerten eingesetzt.

Durch diese Maßnahmen wird sichergestellt, dass die Übertragungseigenschaften in beide Übertragungsrichtungen gleich sind.

In einer weiteren Ausführungsform der Erfindung ist an den ersten Anschluss eines Sender-oder Empfängerbausteins ein erster Widerstand angeschlossen, der mit seinem zweiten Anschluss an der Annode einer Leuchtdiode, einem zweiten und einem dritten Widerstand angeschlossen ist, und der dritte Widerstand mit seinem zweiten Anschluss an einen Kondensator und einen vierten Widerstand angeschlossen ist, wobei der vierte Widerstand mit seinem zweiten Anschluss mit dem zweiten Anschluss des Halbleiterbausteins verbunden ist und der zweiten Anschluss des Kondensators, der zweite Anschluss des zweiten Widerstands und die Kathode der Leuchtdiode mit Masse verbunden sind.

Ein so aufgebautes Netzwerk hat sich in der Praxis als einfach, kostengünstig und von der Funktion her vorteilhaft herausgestellt.

In einer anderen Ausführungsform kann an jeweils einen Eingang von Sender- bzw. Empfängerbaustein, der als Eingang oder Ausgang schaltbar ist, ein Spannungsteiler aus zwei Widerständen nach Masse angeschlossen werden, wobei die Leuchtdiode an dem Teilerpunkt des Spannungsteilers angeschlossen ist. Dadurch wird der Aufbau wesentlich vereinfacht, wobei jedoch auf eine Störungsunterdrückung durch Ausfilterung bestimmter Frequenzbereiche verzichtet wird.

In einer weiteren Ausführungsform der Erfindung wird ein Verfahren zur optischen Signalübertragung vorgeschlagen, bei dem ein Senderbaustein ein optisches Signal sendet und das optische Signal an einem Empfängerbaustein als elektrisches Signal empfangen wird, wobei eine Leuchtdiode, die mit dem Empfängerbaustein elektrisch verbunden ist, das optische Signal in das elektrische Signal umwandelt.

Mit einem solchen Verfahren wird ermöglicht, eine Leuchtdiode als Empfängerbaustein für eine optische Signalübertragung zu verwenden.

In einer weiteren Ausführungsform des Verfahrens findet die optische Signalübertragung bidirektional statt. Dazu wird eine der oben beschriebenen Vorrichtungen für die Übertragung in eine Übertragungsrichtung und die entgegengesetzte Übertragungsrichtung verwendet, indem der Sender der Übertragungsrichtung als Empfänger der entgegengesetzten Übertragungsrichtung und der Empfänger in der Übertragungsrichtung als Sender in der entgegengesetzten Übertragungsrichtung arbeitet.

In einer weiteren Ausführungsform des Verfahrens werden digitale Daten gesendet und empfangen.

In noch einer weiteren Ausführungsform der Erfindung wird ein fernsteuerbares Schließsystem mit einer Fernbedienung und einer Schließeinrichtung vorgeschlagen, die mit der Fernbedienung zusammenwirkt, wobei die Fernbedienung und die Schließeinrichtung ein optisches Signalübertragungssystem in Form einer der oben beschriebenen Ausführungsformen bilden und/oder eines der Verfahren nach der Erfindung anwenden. Die Fernbedienung dient dabei als Schlüssel, der einen Code aussendet, welcher von dem schlossseitigen Empfänger erkannt und ausgewertet wird, um gegebenenfalls einen Zugang zu öffnen.

Ein solches fernsteuerbares Schließsystem weist einen sehr einfachen und kostengünstigen Aufbau auf und ermöglicht in einigen Ausführungsformen eine bidirektionale Kommunikation, was es beispielsweise ermöglicht, dass ein als Schlüssel dienender Sender zunächst von dem schlossseitigen Empfänger, der in einem Lernmodus wahlweise auch als Sender arbeiten kann, einen Code übermittelt bekommt, wobei der schlüsselseitige Sender in diesem Lernmodus als Empfänger geschaltet ist. Damit entfällt eine Codeeingabe über irgendeinen Zwischenträger und der Besitzer des Schlüsselsenders muss nicht einmal den Code kennen, der vielmehr nur zwischen schlossseitigem Empfänger und schüsselseitigem Sender während des Lern- oder Programmiermodus ausgetauscht wird.

In einer weiteren Ausführungsform des Schließsystems wird die Leuchtdiode von der Fernbedienung und/oder der Schließeinrichtung auch als Funktionsanzeige verwendet.

In noch einer weiteren Ausführungsform sendet eine Fernbedienung einen Öffnungscode an einen Schließmechanismus, woraufhin der Schließmechanismus einen Bestätigungscode an die Fernbedienung sendet. In einer weiteren Ausführungsform sendet der Schließmechanismus Informationen zu der Fernbedienung, die einen neuen Öffnungscode enthalten, oder aus denen ein solcher erzeugt werden kann. Auf diese Weise ist ein sogenannter Hopping-Code als Öffnungscode möglich, wobei jedoch auf der Fernbedienung nur ein einziger gültiger Öffnungscode gespeichert sein muss.

In einer anderen Ausführungsform ist das optische Signalübertragungssystem als Adapter zwischen einem ersten Gerät, das eine elektrische Schnittstelle aufweist, und einem zweiten Gerät, das eine Sender-Empfänger-Einheit nach der Erfindung aufweist, ausgestaltet.

Eine der Sender-Empfängereinheiten des optischen Signalübertragungssystems nach der Erfindung ist dabei mit dem Adapter und die zweite in dem zweiten Gerät verbunden. Der Adapter ist im Betrieb mit dem ersten Gerät über die elektrische Schnittstelle verbunden.

Elektrische Schnittstellen können z. B. ein USB-Anschluss, eine RJ45- oder Sub-D-Buchse sein. Diese kann beispielsweise an einer Maschinensteuerung, an einem Computer, elektrischen Messgeräten, z. B. Multimeter, oder dergleichen vorgesehen sein.

Vorteilhaft können die Sender-Empfänger-Einheit des Adapters und die Sender-Empfänger-Einheit des zweiten Geräts mechanisch miteinander lösbar verbunden werden, wobei die Leuchtdioden der Sender-Empfänger-Einheiten optisch miteinander in Kontakt treten.

In einer weiteren Ausführungsform ist das optische Signalübertragungssystem als Optokoppler zur Entkopplung von Potentialen von verschiedenen Geräten oder Komponenten von Geräten ausgestaltet.

Ein solcher Optokoppler kann als monodirektionaler oder bidirektionaler Optokoppler ausgestaltet sein. Die Leuchtdioden in dem Optokoppler sind vorteilhaft in einem gemeinsamen lichtdichten Gehäuse angeordnet und stehen optisch miteinander in Kontakt. Dabei sind die Leuchtdioden als Bauteile mit Kappe oder als Chip vorgesehen.

In einer Ausführungsform berühren sich bei der Signalübertragung die sendende und die empfangende Leuchtdiode. In einer weiteren Ausführungsform habe die Leuchtdioden bei der Signalübertragung einen Abstand bis zu wenigen Zentimetern, z.B. 1, 2 oder 5 cm. Vorteilhaft sind die optischen Achsen der Leuchtdioden bei der Signalübertragung wenigstens näherungsweise aufeinander ausgerichtet.

Weitere Vorteile, Merkmale und Anwendungsmöglichkeiten der Erfindung ergeben sich sowohl aus der folgenden Beschreibung bevorzugter Ausführungsformen, als auch aus den dazugehörigen Figuren. Es zeigen:
Figur 1 einen Schaltplan einer ersten Ausführungsform des optischen Signalübertragungssystems nach der Erfindung,
Figur 2 einen zweiten Schaltplan eines optischen Signalübertragungssystems nach der Erfindung und
Figur 3 einen Schnittstellenadapter, der ein optisches Signalübertragungssystem nach der Erfindung nutzt.

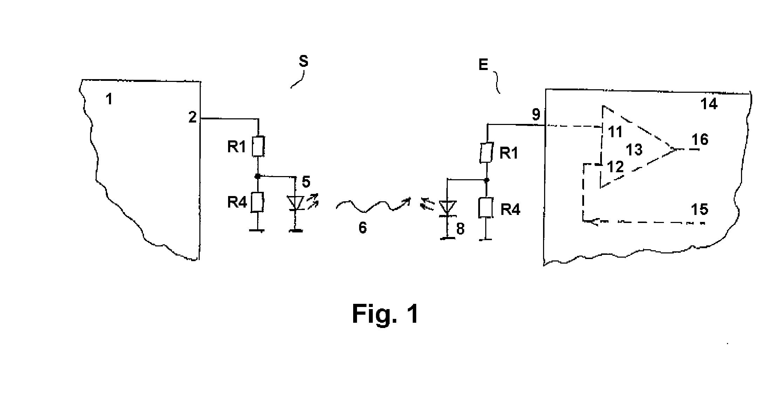

In der Figur 1 ist der Schaltplan eines optischen Signalübertragungssystems nach der Erfindung dargestellt, das aus einem Sender S und einem Empfänger E besteht. Der Sender S umfasst einen Senderbaustein 1 mit einem Anschluss 2, an den ein Spannungsteiler angeschlossen ist, der aus den Widerständen R1 und R4 besteht. An dem Teilerpunkt ist eine Leuchtdiode 5 angeschlossen, die das elektrische Signal, das aus dem Anschluss 2 ausgegeben wird, als optisches Signal abstrahlt. Das optische Signal wird in Form von optischer Strahlung 6 zu der Empfängerdiode 8 übertragen. Diese ist im Betrieb so angeordnet, dass die Strahlung 6 von der Senderdiode 5 auf sie fällt. Der elektrische Aufbau des Empfängers E ist mit dem des Senders S identisch. Dementsprechend ist die Empfängerdiode 8 an den Teilerpunkt eines Spannungsteilers aus Widerständen R1 und R4 angeschlossen. Dabei ist der Widerstand R4 deutlich größer als R1. Der Spannungsteiler ist an einen Empfängerbaustein 14 an dessen Anschluss 9 angeschlossen.

Der Senderbaustein 1 und der Empfängerbaustein 14 sind jeweils als Mikrocontroller vom Typ PIC der Firma Microchip Technology Inc. ausgeführt. Der Anschluss 2 des Senderbausteins 1 ist als Ausgang geschaltet. Der Anschluss 9 des Empfängerbausteins 14 ist als Eingang geschaltet und intern auf einen ersten Anschluss 11 eines Komparators 13 geführt. An den zweiten Anschluss 12 des Komparators 13 ist ein internes Referenzsignal 15 angelegt. Dieses ist zeitlich konstant. Empfangene Lichtsignale 6 werden daher an dem Komparator 13 mit der internen Referenz 15 verglichen und dadurch das ursprünglich gesendete Signal an dem Ausgang des Komparators 16 wiederhergestellt.

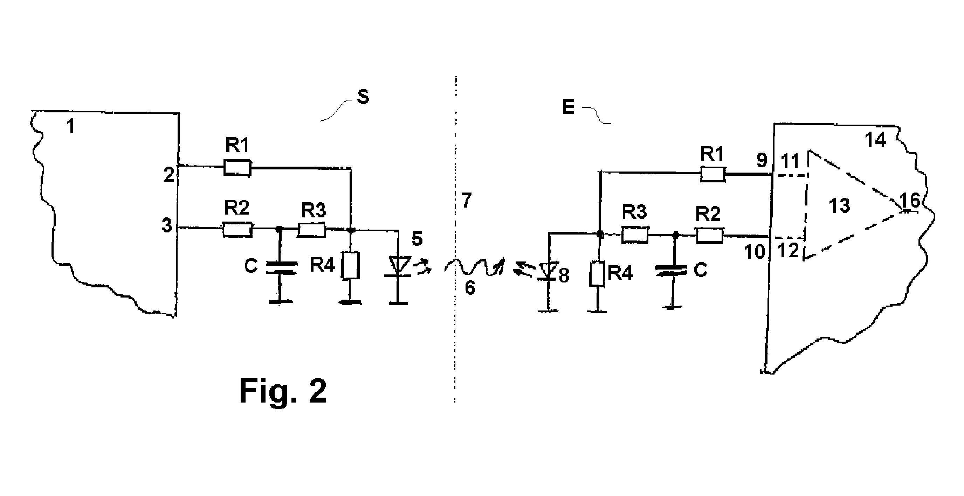

In der Figur 2 ist ein Schaltplan einer weiteren Ausführungsform des optischen Signalübertragungssystems nach der Erfindung gezeigt, das ebenfalls aus einem Sender S und einem Empfänger E besteht, die voneinander unabhängige Einheiten darstellen, wie durch die Trennlinie 7 angedeutet ist.

Der Sender besteht aus einem Senderbaustein 1, der einen ersten Anschluss 2 und einen zweiten Anschluss 3 aufweist. An der ersten Anschluss 2 ist ein Spannungsteiler angeschlossen, der aus den Widerständen R1 und R4 besteht. Dabei ist der Widerstand R4 deutlich größer als R1. An dem Teilerpunkt ist eine Leuchtdiode 5 angeschlossen. An dem Teilerpunkt ist weiter noch ein Tiefpass aus dem Widerstand R3 und einem Kondensator C angeschlossen, dessen Ausgang über einen weiteren Widerstand R2 mit dem zweiten Anschluss 3 des Senderbausteins 1 verbunden ist. Dabei ist der Widerstand R3 deutlich größer als R1.

Im Sendebetrieb gibt der Senderbaustein 1 am Anschluss 2 ein Digitalsignal aus, das über den Spannungsteiler aus R1 und R4 auf die Leuchtdiode 5 gelangt und als optische Strahlung 6 gesendet wird. Der Tiefpassfilter aus R3 und C ist so ausgelegt, dass das Digitalsignal von diesem im Wesentlichen ausgefiltert wird. An den Anschluss 3 des Senderbausteins 1 ist ein konstantes Signal angelegt, so dass von dem Anschluss 3 keine Beeinflussung des gesendeten Signals ausgeht.

Der Empfänger E ist identisch mit dem Sender S aufgebaut. Die empfangende Leuchtdiode 8 ist an den Teilerpunkt eines Spannungsteilers aus den Widerständen R1 und R4 angeschlossen. Der Spannungsteiler ist mit dem zweiten Anschluss des Widerstands R1 mit einem ersten Anschluss 9 des Empfängerbausteins 14 verbunden. An dem Teilerpunkt ist zusätzlich wiederum ein Tiefpassfilter aus einem Widerstand R3 und einem Kondensator C angeschlossen, dessen Ausgang über einen weiteren Widerstand R2 mit einem zweiten Anschluss 10 des Empfängerbausteins 14 verbunden ist.

Der erste Anschluss 9 des Empfängerbausteins 14 ist intern mit einem ersten Eingang 11 eines Komparators 13 verbunden. Der zweite Anschluss 10 des Empfängerbausteins 14 ist intern mit einem zweiten Anschluss 12 des Komparators 13 verbunden.

Elektrische Signale, die von der Leuchtdiode 8 abgegeben werden, werden über den Spannungsteiler aus R1 und R4 ohne Änderungen im Frequenzspektrum an den ersten Anschluss 9 des Empfängerbausteins 14 weitergeleitet. Gleichzeitig wird das von der Leuchtdiode 8 empfangene elektrische Signal durch den Tiefpassfilter aus R3 und C gefiltert und über einen Widerstand R2 an den zweiten Eingang 10 des Empfängerbausteins 14 geleitet. Die Grenzfrequenz des Tiefpassfilters liegt dabei unterhalb der Frequenz des gesendeten Signals. Der Komparator 13 vergleicht daher das unveränderte empfangene Signal mit einem Signal von derselben Quelle, bei dem jedoch nur noch der untere Frequenzbereich vorhanden ist. In dem Signal, das an dem zweiten Eingang 12 des Komparators 13 anliegt, sind daher ausschließlich niederfrequente Störungen enthalten. Durch die Verrechnungsfunktion des Komparators 13 bezüglich der angelegten Signale erscheint an dessen Ausgang 16 die Differenz dieser Signale, so dass hier das gesendete Signal anliegt. Diese Schaltung ist insbesondere für Übertragungsstrecken geeignet, in denen niederfrequente optische Störungen vorliegen, beispielsweise durch Neonlampen oder Kompaktleuchtstofflampen.

Der Senderbaustein 1 und der Empfängerbaustein 14 sind in dieser Ausführungsform als Mikrocontroller vom Typ PIC der Firma Microchip ausgeführt.

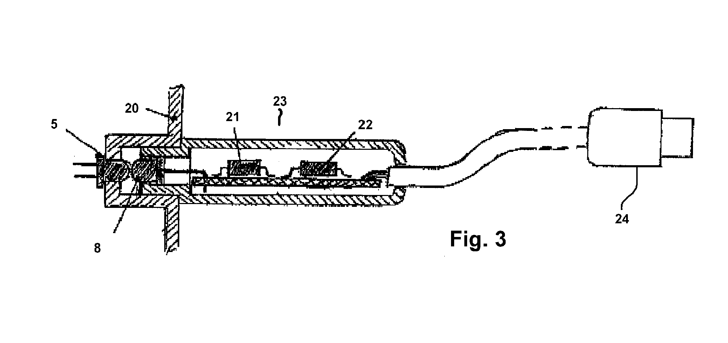

In der Figur 3 ist ein Schnitt eines Adapters zwischen einem USB-Anschluss und einem optischen Signalübertragungssystem nach der Erfindung dargestellt. Ein Auslesekopf 23 ist in eine passende Aussparung eines Steuerungsgehäuses 20 eingesteckt, wobei eine Leuchtdiode 8 des Auslesekopfes 23 und eine Leuchtdiode 5 des Steuerungsgehäuses 20 sich unmittelbar berührend gegenüberstehen. Die Leuchtdiode 5 ist an eine Sende- und Empfangseinheit, die nicht dargestellt ist, angeschlossen. Die Leuchtdiode 8 ist mit einem Mikrocontroller 21 vom Typ PIC elektrisch verbunden. Der Mikrocontroller 21 ist mit einem USB-Schnittstellentreiber 22 elektrisch verbunden. Der USB-Schnittstellentreiber 22 ist mit wiederum einem USB-Stecker 24 verbunden. In einer alternativen Ausführungsform kann der USB-Stecker 24 auch in das Gehäuse des Auslesekopfes 23 integriert sein.

### Bezugszeichenliste

- 1: Senderbaustein
- 2: Erster Anschluss
- 3: Zweiter Anschluss
- 5: Sendende Leuchtdiode
- 6: Optische Strahlung
- 7: Grenze zwischen Sender und Empfänger
- 8: Empfangende Leuchtdiode
- 9: Erster Eingang des Empfängerbausteins
- 10: Zweiter Eingang des Empfängerbausteins
- 11: Erster Eingang des Komparators
- 12: Zweiter Eingang des Komparators
- 13: Komparator
- 14: Empfängerbaustein
- 15: Referenzsignal
- 16: Ausgang des Komparators
- 20: Aussparung eines Steuerungsgehäuses
- 21: Mikrocontroller
- 22: USB-Schnittstellentreiber
- 23: Auslesekopf
- 24: USB-Stecker
- S: Sender
- E: Empfänger
- C: Kondensator
- R1: Widerstand
- R2: Widerstand
- R3: Widerstand
- R4: Widerstand

## Patentansprüche

1. Optischer Signalempfänger (E) mit einem elektrischen Empfängerbaustein (14) zur Verarbeitung der von einem elektrooptischen Empfangselement (8) erzeugten elektrischen Signale, **dadurch gekennzeichnet, dass** der optische Signalempfänger (E) als elektrooptisches Empfangselement (8) für die in elektrische Signale umzuwandelnden optischen Signale eine Leuchtdiode (8) aufweist.

2. Optisches Signalübertragungssystem mit einem Signalsender (S) mit einem elektrischen Senderbaustein (1) und einem Signalempfänger (E) mit einem elektrischen Empfängerbaustein (14) nach Anspruch 1, **dadurch gekennzeichnet, dass** der Senderbaustein (1) mit einer sendenden Leuchtdiode (5) und der Empfängerbaustein (14) mit einer gleichartigen empfangenden Leuchtdiode (8) elektrisch verbunden ist.

3. Optisches Signalübertragungssystem nach einem der vorangehenden Ansprüche, **dadurch gekennzeichnet, dass** die sendende Leuchtdiode (5) und die empfangende Leuchtdiode (8) jeweils mit einem ersten Anschluss (2, 9) des Sender- bzw. Empfängerbausteins (1, 14) elektrisch verbunden ist, wobei die ersten Anschlüsse (2, 9) als Eingang oder Ausgang schaltbar sind und der erste Anschluss (2) des Senderbausteins (1) als Ausgang und der erste Anschluss (9) der Empfängerbausteins (14) als Eingang geschaltet ist.

4. Optisches Signalübertragungssystem nach einem der vorangehenden Ansprüche, **dadurch gekennzeichnet, dass** die sendende Leuchtdiode (5) und die empfangende Leuchtdiode (8) dieselben Kenndaten haben.

5. Optisches Signalübertragungssystem nach einem der vorangehenden Ansprüche, **dadurch gekennzeichnet, dass** es eine rote Leuchtdiode (5) zum Senden und eine rote Leuchtdiode (8) zum Empfangen aufweist.

6. Optisches Signalübertragungssystem nach einem der vorangehenden Ansprüche, **dadurch gekennzeichnet, dass** es je eine Leuchtdiode (5, 8) mit einer maximalen Lichtstärke von mehr als 100 mcd zum Senden und zum Empfangen aufweist.

7. Optisches Signalübertragungssystem, **dadurch gekennzeichnet, dass** der Empfänger- und der Senderbaustein (1, 14) jeweils einen Mikrocontroller aufweist.

8. Optisches Signalübertragungssystem nach einem der vorangehenden Ansprüche, **dadurch gekennzeichnet, dass** die empfangende Leuchtdiode (8) mit dem ersten Anschluss (9) und dem zweiten Anschluss (10) des Empfängerbausteins (14) über ein elektrisches Netzwerk (R1, R2, R3, R4, C) verbunden ist, das aus dem elektrischen Signal zu dem ersten Anschluss (9) und/oder dem zweiten Anschluss (10) einen Teil des Frequenzspektrums ausfiltert, wobei einer der Anschlüsse (9, 10) mit einem positiven Eingang (11, 12) und der andere mit einem negativen Eingang einer Signalverrechnungseinrichtung (12, 11) verbunden ist.

9. Optisches Signalübertragungssystem nach einem der vorangehenden Ansprüche, **dadurch gekennzeichnet, dass** ein zweiter Anschluss (3) an dem Senderbaustein (1), der mit der sendenden Leuchtdiode (5) verbunden ist, als Ausgang geschaltet ist und ein konstantes Signal ausgibt.

10. Optisches Signalübertragungssystem nach einem der vorangehenden Ansprüche, **dadurch gekennzeichnet, dass** das Netzwerk (R1, R2, R3, R4, C) zwischen dem ersten Anschluss (2) und dem zweiten Anschluss (3) des Senderbausteins (1) und der sendenden Leuchtdiode und das Netzwerk (R1, R2, R3, R4, C) zwischen dem ersten Anschluss (9) und dem zweiten Anschluss (10) des Empfängerbausteins (14) und der empfangenden Leuchtdiode (8) identisch aufgebaut sind.

11. Optisches Signalübertragungssystem nach einem der vorangehenden Ansprüche, **dadurch gekennzeichnet, dass** an den ersten Anschluss (2, 9) eines Sender- oder Empfängerbausteins (1, 14) ein erster Widerstand (R1) angeschlossen ist, der mit seinem zweiten Anschluss an der Anode einer Leuchtdiode (5, 8), einem vierten Widerstand (R4) und einem dritten Widerstand (R3) angeschlossen ist, und der dritte Widerstand (R3) mit seinem zweiten Anschluss an einen Kondensator (C) und einen zweiten Widerstand (R2) angeschlossen ist, wobei der zweite Widerstand (R2) mit seinem zweiten Anschluss mit dem zweiten Anschluss (3, 10) des Halbleiterbausteins (1, 14) verbunden ist, und der zweite Anschluss des Kondensators (C), der zweite Anschluss des vierten (R4) Widerstandes und die Kathode der Leuchtdiode (5, 8) mit Masse verbunden sind.

12. Verfahren zur optischen Signalübertragung, bei dem ein Senderbaustein (1) ein optisches Signal sendet und das optische Signal an einem Empfängerbaustein (14) als elektrisches Signal empfangen wird, **dadurch gekennzeichnet, dass** eine Leuchtdiode (8), die mit dem Empfängerbaustein (14) elektrisch verbunden ist, das optische Signal in das elektrische Signal wandelt.

13. Verfahren nach Anspruch 12, **dadurch gekennzeichnet, dass** die optische Signalübertragung bidirektional stattfindet, indem eine Vorrichtung nach Anspruch 2 für die Übertragung in eine erste Übertragungsrichtung und in eine zweite Übertragungsrichtung verwendet wird, indem der Sender (S) der ersten Übertragungsrichtung als Empfänger (E) in der zweiten Übertragungsrichtung und der Empfänger (E) in der ersten Übertragungsrichtung als Sender (S) in der zweiten Übertragungsrichtung arbeitet.

14. Verfahren nach einem der Ansprüche 11 bis 13, **dadurch gekennzeichnet, dass** digitale Daten gesendet und empfangen werden.

15. Fernsteuerbares Schließsystem mit einer Fernbedienung und einer Schließeinrichtung, die mit der Fernbedienung zusammenwirkt, **dadurch gekennzeichnet, dass** er die Fernbedienung und die Schließeinrichtung ein optisches Signalübertragungssystem nach einem der Ansprüche 1 bis 11 bilden und/oder ein Verfahren nach den Ansprüchen 12 bis 14 anwenden.
